(19) **Europäisches Patentamt / European Patent Office / Office européen des brevets**

(11) **EP 4 302 102 B1**

(12) **EUROPÄISCHE PATENTSCHRIFT**

(45) Veröffentlichungstag und Bekanntmachung des Hinweises auf die Patenterteilung:
**15.04.2026   Patentblatt 2026/16**

(21) Anmeldenummer: **22712264.5**

(22) Anmeldetag: **22.02.2022**

(51) Internationale Patentklassifikation (IPC):
**G01R 23/07** *(2006.01)*   **G01R 23/02** *(2006.01)*

(52) Gemeinsame Patentklassifikation (CPC):
**G01R 23/07; G01R 23/02**

(86) Internationale Anmeldenummer:
**PCT/EP2022/054366**

(87) Internationale Veröffentlichungsnummer:
**WO 2022/184498 (09.09.2022 Gazette 2022/36)**

(54) **VORRICHTUNG MIT EINER SECHS-TOR-SCHALTUNG UND BETRIEBSVERFAHREN HIERFÜR**

APPARATUS HAVING A SIX-PORT CIRCUIT, AND METHOD FOR OPERATING SAME

APPAREIL AYANT UN CIRCUIT À SIX PORTS ET PROCÉDÉ POUR LE FAIRE FONCTIONNER

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **02.03.2021   DE 102021105006**

(43) Veröffentlichungstag der Anmeldung:
**10.01.2024   Patentblatt 2024/02**

(73) Patentinhaber:
- **Horst Siedle GmbH & Co. KG.**
  **78120 Furtwangen (DE)**
- **Friedrich-Alexander-Universität Erlangen-Nürnberg**
  **91054 Erlangen (DE)**

(72) Erfinder:
- **HALDER, Ernst**
  **70437 Stuttgart (DE)**
- **LURZ, Fabian**
  **21079 Hamburg (DE)**
- **SEPT-ENZEL, Gerold**
  **70619 Stuttgart (DE)**
- **DINGLER, Peter**
  **73432 Aalen-Ebnat (DE)**
- **SCHEINER, Benedict**
  **91052 Erlangen (DE)**

(74) Vertreter: **DREISS Patentanwälte PartG mbB**
**Friedrichstraße 6**
**70174 Stuttgart (DE)**

(56) Entgegenhaltungen:
**DE-A1- 102013 209 364      DE-A1- 19 638 627
DE-B3- 102016 119 562**

- **SCHEINER BENEDICT ET AL: "Frequency Response Characterization of Surface Acoustic Wave Resonators Using a Six-Port Frequency Measurement System", 2019 KLEINHEUBACH CONFERENCE, URSI LANDESAUSSCHUSS IN DER BUNDESREPUBLIK DEUTSCHLAND E.V, 23 September 2019 (2019-09-23), pages 1 - 4, XP033659784**
- **WEIGEL ROBERT ET AL: "A fast and precise Six-Port-based IFM technique for wireless resonant SAW sensing", 2016 IEEE INTERNATIONAL ULTRASONICS SYMPOSIUM (IUS), IEEE, 18 September 2016 (2016-09-18), pages 1 - 4, XP032988495, DOI: 10.1109/ULTSYM.2016.7728613**

**EP 4 302 102 B1**

## Beschreibung

Die Offenbarung betrifft eine Vorrichtung mit einer Sechs-Tor-Schaltung.

Die Offenbarung betrifft ferner ein Verfahren zum Betreiben einer Vorrichtung mit einer Sechs-Tor-Schaltung.

DE 10 2013 209364 A1 beschreibt ein elektrisches Messsystem mit einer Sechs-Tor-Schaltung und einer Verzögerungsleitung.

SCHEINER BENEDICT ET AL: "Frequency Response Characterization of Surface Acoustic Wave Resonators Using a Six-Port Frequency Measurement System", 2019 KLEINHEUBACH CONFERENCE, URSI LANDESAUSSCHUSS IN DER BUNDESREPUBLIK DEUTSCHLAND E.V, 23. September 2019, Seiten 1-4, XP033659784, beschreibt Frequency Response Characterization of Surface Acoustic Wave Resonators Using a Six-Port Frequency Measurement System.

Beispielhafte Ausführungsformen beziehen sich auf eine Vorrichtung mit einer Sechs-Tor-Schaltung gemäß Anspruch 1.

Bei weiteren beispielhaften Ausführungsformen ist vorgesehen, dass die Verzögerungseinrichtung eine erste Leiterstruktur (z.B. angeordnet auf einer ersten Schaltungsträgerplatte) aufweist, die beispielsweise dazu ausgebildet ist, das erste Eingangssignal um die erste Verzögerungszeit zu verzögern, und/oder dass die Verzögerungseinrichtung eine zweite Leiterstruktur (z.B. angeordnet auf einer "eigenen" zweiten Schaltungsträgerplatte oder bei weiteren beispielhaften Ausführungsformen zusammen mit der ersten Leiterstruktur auf der ersten Schaltungsträgerplatte) aufweist, die beispielsweise dazu ausgebildet ist, das zweite Eingangssignal um die zweite Verzögerungszeit zu verzögern.

Bei weiteren beispielhaften Ausführungsformen, bei denen z.B. die erste Leiterstruktur und die zweite Leiterstruktur vorgesehen sind, kann beispielsweise eine serielle Anordnung vorgesehen sein, bei der die erste Leiterstruktur und die zweite Leiterstruktur beispielsweise in Reihe zueinander geschaltet sind, wobei z.B. die erste Leiterstruktur die erste Verzögerungszeit bewirkt, und wobei die zweite Leiterstruktur, die für sich wie beschrieben z.B. die zweite Verzögerungszeit bewirkt, zusammen mit der ersten Leiterstruktur eine aggregierte Verzögerungszeit bewirkt, die z.B. einer Summe aus der ersten Verzögerungszeit und der zweiten Verzögerungszeit entspricht. Insoweit gilt für beispielhafte Ausführungsformen mit serieller Anordnung bezüglich der aggregierten Verzögerungszeit das weiter unten für die zweite Verzögerungszeit Beschriebene (z.B. Werte für die Verzögerungszeit) bei weiteren beispielhaften Ausführungsformen entsprechend. Bei weiteren beispielhaften Ausführungsformen, bei denen z.B. die erste Leiterstruktur und die zweite Leiterstruktur vorgesehen sind, kann beispielsweise eine parallele Anordnung vorgesehen sein, bei der die erste Leiterstruktur die erste Verzögerungszeit bewirkt, und bei der die zweite Leiterstruktur die zweite Verzögerungszeit bewirkt.

Bei weiteren beispielhaften Ausführungsformen ist vorgesehen, dass die Verzögerungseinrichtung eine Leistungsteilereinrichtung aufweist, die dazu ausgebildet ist, das Eingangssignal in das erste Eingangssignal und das zweite Eingangssignal zu teilen.

Bei weiteren beispielhaften Ausführungsformen ist vorgesehen, dass die erste OFW-Verzögerungsleitung und/oder die zweite OFW-Verzögerungsleitung jeweils als diskrete OFW-Verzögerungsleitung ausgebildet ist.

Bei weiteren beispielhaften Ausführungsformen ist vorgesehen, dass die Leistungsteilereinrichtung als diskretes Bauelement vorgesehen ist.

Bei weiteren beispielhaften Ausführungsformen ist vorgesehen, dass zusätzlich wenigstens eines der folgenden Elemente auf der Schaltungsträgerplatte angeordnet ist: a) die Leistungsteilereinrichtung, oder b) die erste Leiterstruktur, oder c) die zweite Leiterstruktur.

Bei weiteren beispielhaften Ausführungsformen ist vorgesehen, dass ein Betrag einer Differenz zwischen der ersten Verzögerungszeit und der zweiten Verzögerungszeit zwischen, beispielsweise etwa, 1 Nanosekunde, ns, und, beispielsweise etwa, 1000 ns liegt, beispielsweise zwischen 10 ns und 200 ns, beispielsweise 100 ns beträgt.

Bei weiteren beispielhaften Ausführungsformen ist vorgesehen, dass die erste Verzögerungszeit und/oder die zweite Verzögerungszeit zwischen, beispielsweise etwa, 0,5 Mikrosekunden, $\mu$s, und, beispielsweise etwa, 10 $\mu$s liegt, beispielsweise zwischen 1 $\mu$s und 3 $\mu$s, beispielsweise 2 $\mu$s beträgt.

Weitere beispielhafte Ausführungsformen beziehen sich auf ein Messsystem nach Anspruch 8.

Bei weiteren beispielhaften Ausführungsformen kann anstelle des Resonators z.B. auch eine andersartige Signalquelle für das Messsystem verwendet werden, deren Signalfrequenz z.B. von einer zu ermittelnden Größe abhängt.

Bei weiteren beispielhaften Ausführungsformen ist vorgesehen, dass das Messsystem zur Messung wenigstens einer der folgenden Größen ausgebildet ist: a) mechanische Spannungen, beispielsweise charakterisierbar bzw. assoziierbar mit Biegung und/oder Stauchung und/oder Dehnung und/oder Torsion, b) Drehmoment, c) Kraft, beispielsweise als Kraftsensor und/oder Kraftaufnehmer und/oder Kraftmessdose und/oder Kraftmessplatte, d) Temperatur, e) Druck, f) Vibration, g) Schock, h) Resonanzen, i) Scherkräfte, j) Querkräfte, k) Elastizität, l) Verformung, m) Kontraktion.

Bei weiteren beispielhaften Ausführungsformen ist vorgesehen, dass das Messsystem wenigstens einen Signalgenerator aufweist, der dazu ausgebildet ist, ein Signal bereitzustellen, beispielsweise ein Anregungssignal für einen bzw. den Resonator und/oder ein Referenzsignal, beispielsweise für die Sechs-Tor-Schaltung.

Bei weiteren beispielhaften Ausführungsformen ist vorgesehen, dass das Messsystem eine Koppeleinrichtung aufweist, die dazu ausgebildet ist, ein bzw. das Anregungssignal an wenigstens einen Resonator auszugeben und ein Ausgangssignal des wenigstens einen Resonators zu empfangen und an wenigstens einen Eingang der Sechs-Tor-Schaltung und/oder an die Verzögerungseinrichtung auszugeben.

Weitere beispielhafte Ausführungsformen beziehen sich auf ein Verfahren zum Betreiben einer Vorrichtung mit einer Sechs-Tor-Schaltung, einer Verzögerungseinrichtung, und einer Recheneinrichtung, aufweisend: Teilen, mittels der Verzögerungseinrichtung, eines Eingangssignals in ein erstes Eingangssignal und ein zweites Eingangssignal, Verzögern des ersten Eingangssignals um eine erste Verzögerungszeit, mittels der Verzögerungseinrichtung, wobei beispielsweise ein erstes verzögertes Eingangssignal erhalten wird, Verzögern des zweiten Eingangssignals um eine zweite Verzögerungszeit, mittels der Verzögerungseinrichtung, wobei beispielsweise ein zweites verzögertes Eingangssignal erhalten wird, wobei die zweite Verzögerungszeit verschieden ist von der ersten Verzögerungszeit, Ausgeben, mittels der Verzögerungseinrichtung, des ersten verzögerten Eingangssignals an einen ersten Eingang der Sechs-Tor-Schaltung , Ausgeben, mittels der Verzögerungseinrichtung, des zweiten verzögerten Eingangssignals an einen zweiten Eingang der Sechs-Tor-Schaltung, Ermitteln, mittels der Recheneinrichtung, einer eine Frequenz des Eingangssignals charakterisierenden erste Größe in Abhängigkeit wenigstens eines Ausgangssignals der Sechs-Tor-Schaltung.

Bei weiteren beispielhaften Ausführungsformen ist vorgesehen, dass die Verzögerungseinrichtung eine erste Oberflächenwellen, OFW-, Verzögerungsleitung und eine zweite Oberflächenwellen, OFW-, Verzögerungsleitung aufweist, wobei das Verfahren aufweist: Verzögern, mittels der ersten Oberflächenwellen, OFW-, Verzögerungsleitung, des ersten Eingangssignals um die erste Verzögerungszeit, Verzögern, mittels der zweiten Oberflächenwellen, OFW-, Verzögerungsleitung, des zweiten Eingangssignals um die zweite Verzögerungszeit.

Bei weiteren beispielhaften Ausführungsformen ist vorgesehen, dass das Verfahren wenigstens eines der folgenden Elemente aufweist: a) Anschalten bzw. Initialisieren der Vorrichtung bzw. eines die Vorrichtung aufweisenden Messsystems, b) Ermitteln einer Hauptresonanz eines Resonators, c) Ausführen einer Leistungskalibrierung, d) Ausführen einer Linearisierung, e) Ermitteln der ersten Größe bzw. der Frequenz des Eingangssignals, optional Anpassen einer Frequenz eines an den Resonator gesendeten Anregungssignals.

Weitere beispielhafte Ausführungsformen beziehen sich auf eine Verwendung der Vorrichtung gemäß den Ausführungsformen und/oder des Messsystems gemäß den Ausführungsformen und/oder des Verfahrens gemäß den Ausführungsformen für wenigstens eines der folgenden Elemente bzw. auf wenigstens einem der folgenden Gebiete: a) Ermitteln einer eine Frequenz des Eingangssignals charakterisierenden ersten Größe, b) Messung von mechanischen Spannungen, beispielsweise charakterisierbar bzw. assoziierbar mit Biegung und/oder Stauchung und/oder Dehnung und/oder Torsion, c) Messung eines Drehmoments, d) Messung einer Kraft, e) Messung einer Temperatur, f) Messung eines Drucks, g) Messung von Vibration bzw. Vibrationen, h) Messung von Schock, i) Messung von Resonanzen, j) Automotive, z.B. Getriebe, Zapfwellen, Achsen, Lenksäulen, tragende Karosseriekomponenten, k) E-Bikes bzw. Pedelecs, l) Arbeitsmaschinen, beispielsweise mobile Arbeitsmaschinen, beispielsweise Getriebe, Zapfwellen, Achsen, Lenksäulen, tragenden Karosseriekomponenten, Dämpfer, Stoßdämpfer, m) elektrische Antriebe, n) Bauwerke bzw. Gebäude, beispielsweise bezüglich Statik, Bauwerkskomponenten, Brückenüberwachung, Windlast, Erdbebenmonitoring, Erfassung beispielsweise geologischer Veränderungen, Schneelast, Belastung, Gebäudemonitoring, o) Energieerzeugung, beispielsweise Kraftwerksapplikationen, Windkraftanlagen, Rotorblattmonitoring, Pitchverstellung, Wasserkraft, p) Gewichtserfassung, beispielsweise Waagen, industrielles Wiegen, Überlastschutz, q) Temperaturmessung und/oder -überwachung, beispielsweise, Öfen, Kochen, Fleischzubereitung und/oder -verarbeitung, r) Aufzüge, beispielsweise Lasten-/Personenaufzüge, s) industrielle Anwendungen im Maschinenbau, beispielsweise Messtechnik für Prüf- und Teststände, t) Überwachung, beispielsweise Steuerung und/oder Regelung von Turbinen, Pumpen, Pressen, Stanzen, Umformen, u) Medizintechnik, beispielsweise Exoskellette, Protesen, OP-Tische, Betten, v) Luft- und Raumfahrt, beispielsweise Fahrwerksbelastung, Tragflächenmonitoring, Überwachung Steuerruder, w) Schifffahrt, beispielsweise Marineanwendungen, x) Bahnanwendungen, beispielsweise Gleisbau, Antriebstechnik, Zuglast, y) Umsetzung einer funktionalen Sicherheit, z) Weiße Ware, Waschmaschine, Trommelüberwachung, Trockner, A) Fluidtechnik, Ventile, Klappen, Rohre, B) Qualitätssicherung, beispielsweise Prozessüberwachung, C) Ermittlung und/oder Auswertung von chemischen Zusammensetzungen von Fluiden, z.B. Flüssigkeiten und/oder Gasen.

Weitere Merkmale, Anwendungsmöglichkeiten und Vorteile der Erfindung ergeben sich aus der nachfolgenden Beschreibung von Ausführungsbeispielen der Erfindung, die in den Figuren der Zeichnung dargestellt sind. Dabei bilden alle beschriebenen oder dargestellten Merkmale für sich oder in beliebiger Kombination den Gegenstand der Erfindung, unabhängig von ihrer Zusammenfassung in den Patentansprüchen oder deren Rückbeziehung sowie unabhängig von ihrer Formulierung bzw. Darstellung in der Beschreibung bzw. in den Figuren.

In der Zeichnung zeigt:

Fig. 1 schematisch ein vereinfachtes Blockdiagramm gemäß beispielhaften Ausführungsformen,

Fig. 2　　schematisch ein vereinfachtes Flussdiagramm gemäß weiterer beispielhaften Ausführungsformen,

Fig. 3A　　schematisch ein vereinfachtes Blockdiagramm gemäß weiterer beispielhaften Ausführungsformen,

Fig. 3B　　schematisch ein vereinfachtes Blockdiagramm gemäß weiterer beispielhaften Ausführungsformen,

Fig. 4　　schematisch ein vereinfachtes Blockdiagramm gemäß weiterer beispielhaften Ausführungsformen,

Fig. 5　　schematisch ein vereinfachtes Blockdiagramm gemäß weiterer beispielhaften Ausführungsformen,

Fig. 6　　schematisch ein vereinfachtes Blockdiagramm gemäß weiterer beispielhaften Ausführungsformen,

Fig. 7　　schematisch ein vereinfachtes Flussdiagramm gemäß weiterer beispielhaften Ausführungsformen, und

Fig. 8　　schematisch Aspekte von Verwendungen gemäß weiterer beispielhaften Ausführungsformen.

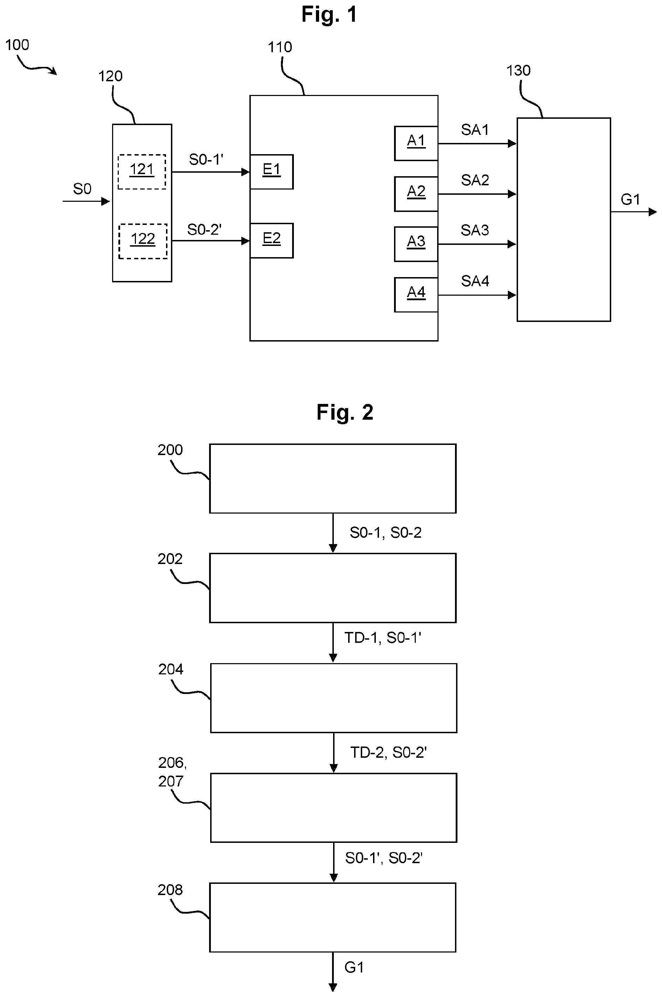

Beispielhafte Ausführungsformen, vgl. Fig. 1 und 2, beziehen sich auf eine Vorrichtung 100 mit einer Sechs-Tor-Schaltung 110, einer Verzögerungseinrichtung 120, und einer Recheneinrichtung 130, wobei die Verzögerungseinrichtung 120 dazu ausgebildet ist, ein Eingangssignal S0 in ein erstes Eingangssignal S0-1 und ein zweites Eingangssignal S0-2 zu teilen 200 (Fig. 2), das erste Eingangssignal S0-1 um eine erste Verzögerungszeit TD-1 zu verzögern 202, wobei beispielsweise ein erstes verzögertes Eingangssignal S0-1' erhalten wird, das zweite Eingangssignal S0-2 um eine zweite Verzögerungszeit TD-2 zu verzögern 204, wobei beispielsweise ein zweites verzögertes Eingangssignal S0-2' erhalten wird, wobei die zweite Verzögerungszeit TD-2 verschieden ist von der ersten Verzögerungszeit TD-1, wobei die Verzögerungseinrichtung 120 dazu ausgebildet ist, das erste verzögerte Eingangssignal S0-1' an einen ersten Eingang E1 (Fig. 1) der Sechs-Tor-Schaltung 110 auszugeben 206, das zweite verzögerte Eingangssignal S0-2' an einen zweiten Eingang E2 der Sechs-Tor-Schaltung 110 auszugeben 207, wobei die Recheneinrichtung 130 dazu ausgebildet ist, eine eine Frequenz des Eingangssignals S0 charakterisierende erste Größe G1 in Abhängigkeit wenigstens eines Ausgangssignals SA1, SA2, SA3, SA4 der Sechs-Tor-Schaltung 110 zu ermitteln 208.

Bei weiteren beispielhaften Ausführungsformen weist das zweite verzögerte Eingangssignal S0-2' z.B. aufgrund der unterschiedlichen Verzögerungszeiten TD-1, TD-2 eine Phasenverschiebung d_phi gegenüber dem ersten verzögerten Eingangssignal S0-1' auf. Die Phasenverschiebung d_phi hängt bei weiteren beispielhaften Ausführungsformen von der Frequenz des Eingangssignals S0 gemäß der folgenden Gleichung ab: d_phi = 2 * Pi * f * t_dl, wobei "*" der Multiplikationsoperator ist, wobei Pi die Kreiszahl (3,141...) ist, wobei f die Frequenz des Eingangssignals S0 ist, wobei t_dl eine Differenz der Verzögerungszeiten TD-1, TD-2 ist, welcher das erste bzw. zweite Eingangssignal S0-1, S0-2 bei Durchlaufen der Verzögerungseinrichtung 120 unterworfen wird.

Bei weiteren beispielhaften Ausführungsformen ist die Sechs-Tor-Schaltung 110 dazu ausgebildet, die durch die Verzögerungseinrichtung 120 verursachte Phasenverschiebung zwischen den verzögerten Eingangssignalen S0-1', S0-2' auszuwerten. Hierzu kann die Sechs-Tor-Schaltung 110 bei weiteren beispielhaften Ausführungsformen beispielsweise die beiden verzögerten Eingangssignale S0-1', S0-2', die sie an ihren Eingängen E1, E2 empfängt, unter vier verschiedenen Phasenverschiebungen von z.B. 0°, 90°, 180°, 270° einander überlagern, wodurch insgesamt vier Ausgangssignale SA1, SA2, SA3, SA4 erhalten werden, die die Sechs-Tor-Schaltung 110 bei weiteren beispielhaften Ausführungsformen an den Ausgängen A1, A2, A3, A4 ausgibt.

Bei weiteren beispielhaften Ausführungsformen ist die Sechs-Tor-Schaltung 110 dazu ausgebildet, die vier Ausgangssignale SA1, SA2, SA3, SA4 einer Frequenzabwärtsumsetzung zu unterziehen. Bei weiteren beispielhaften Ausführungsformen werden dadurch jeweils Basisbandsignale als vier Ausgangssignale SA1, SA2, SA3, SA4 erhalten.

Bei weiteren beispielhaften Ausführungsformen werden die vier Ausgangssignale SA1, SA2, SA3, SA4, z.B. in Form der beispielhaft genannten Basisbandsignale, als einen komplexen Ausgangsvektor Z = (SA3-SA4) + j (SA1-SA2) charakterisierend interpretiert, wobei sich aus der Phase des Ausgangsvektors Z in an sich bekannter Weise die vorstehend genannte Phasenverschiebung d_phi ermitteln lässt, vgl. die folgende Gleichung: d_phi = $\tan^{-1}$((SA1-SA2)/(SA3-SA4)), wobei $\tan^{-1}$() die inverse Tangensfunktion (Arkustangens) ist. Sofern die Differenz t_dl der Verzögerungszeiten TD-1, TD-2 bekannt ist, kann bei weiteren beispielhaften Ausführungsformen die Frequenz des Eingangssignals S0, beispielsweise repräsentierbar durch die erste Größe G1, wie folgt ermittelt werden:

```
G1 = (d_phi) / (2*Pi*t_dl).
```

Bei weiteren beispielhaften Ausführungsfor-

men kann alternativ oder ergänzend auch eine z.B. abschnittsweise definierte atan2 (arctan2)-Funktion verwendet werden, z.B. um einen Eindeutigkeitsbereich über 2 pi zu erhalten, z.B. gemäß atan2((SA1-SA2), (SA3-SA4)).

Die vorstehend genannten Berechnungen können bei weiteren beispielhaften Ausführungsformen z.B. durch die Recheneinrichtung 130 z.B. unter Verwendung der Sechs-Tor-Schaltung 110 ausgeführt werden.

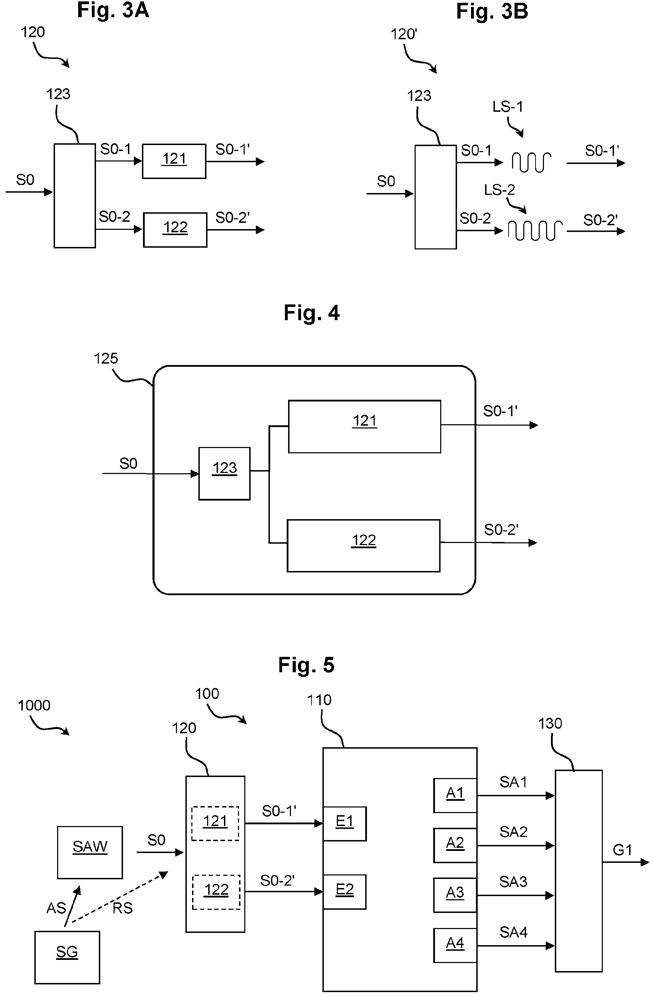

Bei weiteren beispielhaften Ausführungsformen, Fig. 3A, ist vorgesehen, dass die Verzögerungseinrichtung 120 eine erste Oberflächenwellen-, OFW-, Verzögerungsleitung 121 aufweist, die beispielsweise dazu ausgebildet ist, das erste Eingangssignal S0-1 um die erste Verzögerungszeit TD-1 zu verzögern, wobei die Verzögerungseinrichtung 120 eine zweite Oberflächenwellen-, OFW-, Verzögerungsleitung 122 aufweist, die beispielsweise dazu ausgebildet ist, das zweite Eingangssignal S0-2 um die zweite Verzögerungszeit TD-2 zu verzögern, was z.B. auf die beiden verzögerten Eingangssignale S0-1', S0-2' führt.

Bei weiteren beispielhaften Ausführungsformen ist vorgesehen, dass die Verzögerungseinrichtung 120 eine Leistungsteilereinrichtung 123 aufweist, die dazu ausgebildet ist, das Eingangssignal S0 in das erste Eingangssignal S0-1 und das zweite Eingangssignal S0-2 zu teilen, z.B. mit jeweils gleicher Leistung (z.B. Teilungsfaktor 0,5).

Bei weiteren beispielhaften Ausführungsformen ist vorgesehen, dass die erste OFW-Verzögerungsleitung 121 und/oder die zweite OFW-Verzögerungsleitung 122 jeweils als diskrete OFW-Verzögerungsleitung ausgebildet ist. Dies bedingt eine große Flexibilität z.B. hinsichtlich der Auswahl bzw. Kombination der Verzögerungszeiten TD-1, TD-2.

Bei weiteren beispielhaften Ausführungsformen ist vorgesehen, dass die erste OFW-Verzögerungsleitung 121 und die zweite OFW-Verzögerungsleitung 122 jeweils als separates OFW-Verzögerungsleitungs-Bauteil ausgebildet ist, was z.B. eine physische Trennung der beiden Verzögerungsleitungen voneinander und damit eine bessere Entkopplung bewirkt, beispielsweise, wenn beide Verzögerungsleitungen nicht als ein einziges Bauteil ausgebildet bzw. auf demselben Substrat angeordnet sind.

Fig. 3B zeigt eine zu der Konfiguration gemäß Fig. 3A ähnliche Konfiguration einer Verzögerungseinrichtung 120' gemäß weiteren beispielhaften Ausführungsformen, bei der die Signalverzögerungen anstelle der OFW-Verzögerungsleitungen gemäß Fig. 3A mittels zwei Leiterstrukturen LS-1, LS-2 realisiert werden, die vorliegend beispielhaft jeweils als abgerundete mäanderförmige Linien symbolisiert sind.

Bei weiteren beispielhaften Ausführungsformen (nicht gezeigt) ist es auch denkbar, dass die Verzögerungseinrichtung 120 eine Signalverzögerung bewirkende Elemente unterschiedlichen Typs aufweist, z.B. eine OFW-Verzögerungsleitung zur Realisierung der ersten Verzögerungszeit und z.B. eine Leiterstruktur zur Realisierung der zweiten Verzögerungszeit.

Bei weiteren beispielhaften Ausführungsformen, Fig. 4, ist vorgesehen, dass die Verzögerungseinrichtung 120 eine Schaltungsträgerplatte 125 aufweist, und wobei wenigstens eines der folgenden Elemente auf der Schaltungsträgerplatte 125 angeordnet ist: a) die erste OFW-Verzögerungsleitung 121, b) die zweite OFW-Verzögerungsleitung 122, c) die Leistungsteilereinrichtung 123, d) die erste Leiterstruktur LS-1, e) die zweite Leiterstruktur LS-2.

Bei weiteren beispielhaften Ausführungsformen ist vorgesehen, dass ein Betrag einer Differenz zwischen der ersten Verzögerungszeit TD-1 und der zweiten Verzögerungszeit TD-2 zwischen, beispielsweise etwa, 1 Nanosekunde, ns, und, beispielsweise etwa, 1000 ns liegt, beispielsweise zwischen 10 ns und 200 ns, beispielsweise 100 ns beträgt.

Bei weiteren beispielhaften Ausführungsformen ist vorgesehen, dass die erste Verzögerungszeit TD-1 und/oder die zweite Verzögerungszeit TD-2 zwischen, beispielsweise etwa, 1 Mikrosekunde, µs, und, beispielsweise etwa, 10 µs liegt, beispielsweise zwischen 1 µs und 3 µs, beispielsweise 2 µs beträgt.

Bei weiteren beispielhaften Ausführungsformen beträgt die erste Verzögerungszeit TD-1 2,0 µs und die zweite Verzögerungszeit TD-2 2,1 µs.

Weitere beispielhafte Ausführungsformen, Fig. 5, beziehen sich auf ein Messsystem 1000 aufweisend wenigstens eine Vorrichtung 100 gemäß den Ausführungsformen und wenigstens einen Resonator SAW, der dazu ausgebildet ist, das Eingangssignal S0 bereitzustellen, wobei beispielsweise der wenigstens eine Resonator SAW als akustischer Oberflächenwellenresonator ausgebildet ist.

Bei weiteren beispielhaften Ausführungsformen ist vorgesehen, dass das Messsystem 1000 zur Messung wenigstens einer der folgenden Größen ausgebildet ist: a) mechanische Spannungen, beispielsweise charakterisierbar bzw. assoziierbar mit Biegung und/oder Stauchung und/oder Dehnung und/oder Torsion, b) Drehmoment, c) Kraft, beispielsweise als Kraftsensor und/oder Kraftaufnehmer und/oder Kraftmessdose und/oder Kraftmessplatte, d) Temperatur, e) Druck, f) Vibration, g) Schock, h) Resonanzen, i) Scherkräfte, j) Querkräfte, k) Elastizität, l) Verformung, m) Kontraktion, und/oder eine chemische Zusammensetzung.

Bei weiteren beispielhaften Ausführungsformen ist vorgesehen, dass das Messsystem 1000 wenigstens einen Signalgenerator SG aufweist, der dazu ausgebildet ist, ein Signal bereitzustellen, beispielsweise ein Anregungssignal AS für den Resonator SAW und/oder ein Referenzsignal RS, beispielsweise für die Sechs-Tor-Schaltung.

Bei weiteren beispielhaften Ausführungsformen ist der Resonator SAW beispielsweise durch eine Beaufschlagung mit dem Anregungssignal AS zu einer Schwingung anregbar. Beispielsweise kann der Resonator SAW als "Antwort" bzw. Reaktion auf die Beaufschlagung mit dem Anregungssignal AS das Eingangssignal S0 für die Vorrichtung 100 abgeben.

Bei weiteren beispielhaften Ausführungsformen entspricht die Frequenz des Eingangssignals S0 einer (z.B. momentanen) Resonanz-Frequenz des Resonators SAW, die bei weiteren beispielhaften Ausführungsformen z.B. unter anderem abhängig sein kann von der Temperatur und/oder dem Druck und/oder der Dehnung und/oder anderen physikalischen Größen und/oder Umwelteinflüssen, dem bzw. denen der Resonator SAW ausgesetzt ist. Eine Änderung der Temperatur und/oder des Drucks und/oder der Dehnung des Resonators und/oder einer der anderen physikalischen Größen und/oder Umwelteinflüsse führt dann z.B. zu einer Änderung der Resonanzfrequenz des Resonators SAW, was bei weiteren beispielhaften Ausführungsformen von der Sechs-Tor-Schaltung 110 ermittelt werden kann.

Auf diese Weise kann die Sechs-Tor-Technologie beispielsweise zur Ermittlung einer Temperatur oder eines Drucks oder einer (mechanischen) Dehnung oder anderer Größen bzw. Umwelteinflüsse zum Einsatz kommen. Vorteilhaft kann damit beispielsweise eine mechanische Beanspruchung eines Maschinenelements, beispielsweise eine Torsion einer Welle, ermittelt werden.

Bei weiteren beispielhaften Ausführungsformen ist vorgesehen, dass der Signalgenerator SG dazu ausgebildet ist, zeitweise das Referenzsignal RS z.B. für die Verzögerungseinrichtung 120 und/oder das Anregungssignal AS für den Resonator SAW bereitzustellen. Mit Hilfe des Anregungssignals AS wird z.B. der Resonator SAW mit Energie aufgeladen. Diese Energie kann dann der Resonator SAW wieder abgeben, und zwar über das Antwortsignal AS mit der Resonanzfrequenz. Bei weiteren beispielhaften Ausführungsformen liegt die Frequenz des Anregungssignals AS zumindest etwa im Bereich der Resonanzfrequenz des Resonators SAW, um diesen hinreichend anzuregen.

Bei weiteren beispielhaften Ausführungsformen kann der Signalgenerator SG das Referenzsignal RS direkt an die Verzögerungseinrichtung 120 abgeben. Da die Frequenz des Referenzsignals RS i.d.R. bekannt ist, kann hierdurch z.B. wenigstens eine Komponente 110, 120 bzw. die Vorrichtung 100 linearisiert werden.

Bei weiteren beispielhaften Ausführungsformen weist der Signalgenerator SG beispielsweise einen Oszillator, insbesondere einen steuerbaren Oszillator, auf. Beispielsweise kann der Signalgenerator SG einer Ausführungsform zufolge einen spannungsgesteuerten Oszillator (VCO, voltage controlled oscillator) aufweisen. Eine Steuerung des Oszillators kann beispielsweise durch die Recheneinrichtung 130 des Messsystems 1000 ausgeführt werden.

Bei weiteren beispielhaften Ausführungsformen weist der Signalgenerator SG einen Frequenzsynthesizer auf, bei dem dem Oszillator eine Phasenregelschleife (PLL, phase locked loop) zugeordnet ist, wodurch in an sich bekannter Weise ein besonders frequenzstabiles Signal zum Beispiel für eine Verwendung als Referenzsignal RS und/oder Anregungssignal AS erzeugbar ist. Bei weiteren beispielhaften Ausführungsformen ist der Signalgenerator SG für eine direkte digitale Synthese (DDS) z.B. des Referenzsignals RS und/oder des Anregungssignals AS ausgebildet.

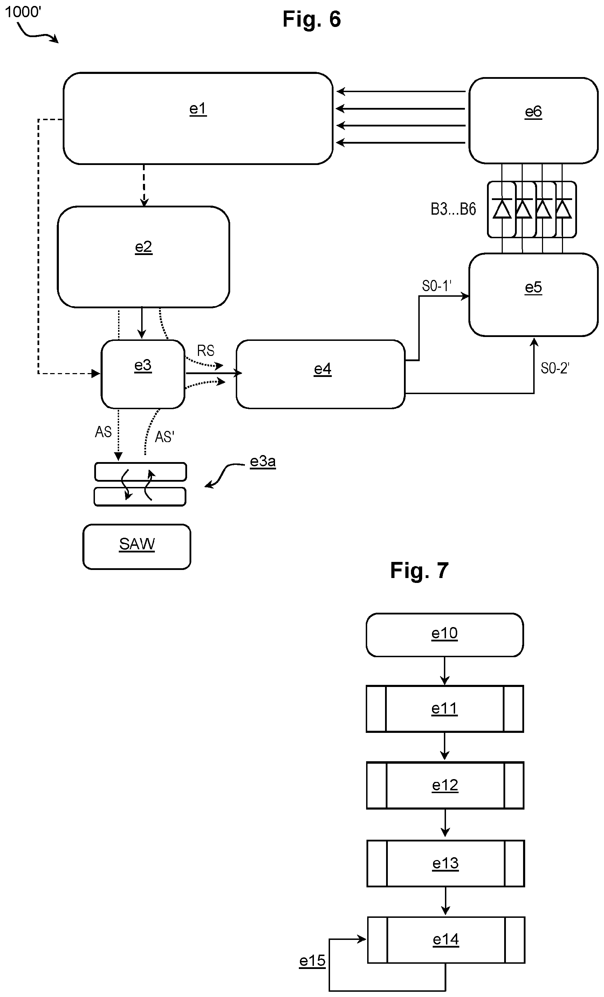

Fig. 6 zeigt schematisch ein vereinfachtes Blockdiagramm eines Messsystems 1000' gemäß weiteren beispielhaften Ausführungsformen. Block e1 symbolisiert eine z.B. als Mikrocontroller ausgebildete Recheneinrichtung, Block e2 symbolisiert einen Frequenz-Synthesizer zur zumindest zeitweisen Bereitstellung eines Signals, z.B. eines Anregungssignals AS für den Resonator SAW und/oder eines Referenzsignals RS für die Verzögerungseinrichtung e4.

Block e3 symbolisiert einen 3-Tor-Schalter, der bei weiteren beispielhaften Ausführungsformen dazu ausgebildet ist, das von dem Frequenz-Synthesizer e2 erzeugte Signal zumindest zeitweise einer Koppeleinrichtung e3a zuzuführen, die dazu ausgebildet ist, das von dem Frequenz-Synthesizer e2 erzeugte Signal als Anregungssignal AS an den Resonator SAW auszugeben. Der 3-Tor-Schalter e3 ist weiter dazu ausgebildet, zumindest zeitweise ein Ausgangssignal AS' des Resonators SAW zu empfangen und an die Verzögerungseinrichtung e4 auszugeben.

Bei weiteren beispielhaften Ausführungsformen ist der 3-Tor-Schalter e3 dazu ausgebildet, zumindest zeitweise das von dem Frequenz-Synthesizer e2 erzeugte Signal als Referenzsignal RS direkt (also z.B. nicht über den Resonator SAW) an die Verzögerungseinrichtung e4 auszugeben, was bei weiteren beispielhaften Ausführungsformen z.B. für eine Linearisierung wenigstens einer der Komponenten e4, e5 verwendbar ist.

Der Block e5 symbolisiert die Sechs-Tor-Schaltung (vgl. auch Bezugszeichen 110 gemäß Fig. 1), der Block e6 symbolisiert eine Verarbeitungseinrichtung, die z.B. eine Verstärkung und/oder Filterung der Ausgangssignale der Sechs-Tor-Schaltung e5 ausführen kann. Die Diodensymbole B3...B6 zwischen den Blöcken e5, e6 symbolisieren eine optionale Frequenzabwärtsumsetzung der Ausgangssignale der Sechs-Tor-Schaltung e5, z.B. in eine Basisbandlage, was eine besonders einfache, kostengünstige und effiziente Weiterverarbeitung z.B. durch den Block e6 bzw. Auswertung durch die Recheneinrichtung e1 ermöglicht.

Bei weiteren beispielhaften Ausführungsformen kann die Auswertung durch die Recheneinrichtung e1 z.B. eine Transformation der z.B. als analoge (z.B. wertekontinuierliche und z.B. zeitkontinuierliche) Basisbandsignale vorliegenden Ausgangssignale des Blocks e6 zu digitalen Signalen (z.B. wertediskret und zeitdiskret) aufweisen, sowie z.B. eine Ermittlung der ersten Größe G1 im Wege einer digitalen Signalverarbeitung bzw. Berechnung durch den Mikrocontroller e1.

Bei weiteren beispielhaften Ausführungsformen kann der Mikrocontroller e1 z.B. als Schnittstelle zwischen einem Host (nicht gezeigt), z.B. einem Industriecomputer, und dem Messsystem 1000' arbeiten. Bei weiteren beispielhaften Ausführungsformen empfängt und verarbeitet der Mikrocontroller e1 die von dem Host gesendeten Anweisungen, sendet Messdaten an diesen zurück und stellt z.B. aktive Komponenten ein.

Bei weiteren beispielhaften Ausführungsformen kann z.B. eine serielle Schnittstelle z.B. vom Typ "universelles serielles Bussystem" (universal serial bus, USB) oder die universelle synchrone und asynchrone serielle Empfänger- und Senderschnittstelle (universal synchronous asynchronous receiver transmitter, USART) bei dem Mikrocontroller e1 vorgesehen sein.

Bei weiteren beispielhaften Ausführungsformen werden mittels des Mikrocontrollers e1 z.B. die aktiven Bausteine der Signalerzeugung (z.B. Block e2) und/oder der $_3$-Tor-Schalter e3 angesteuert und/oder die z.B. analogen Ausgangssignale des "Sechstorempfängers" e5 (bzw. die mittels Block e6 verarbeiteten Signale) abgetastet und somit z.B. digitalisiert.

Da der Sechstorempfänger e5 vier Ausgänge (s. Elemente A1, A2, A3, A4 gemäß Fig. 1) aufweist, ist es bei weiteren beispielhaften Ausführungsformen vorteilhaft, z.B. für hohe Messwertaktualisierungsraten und/oder minimale Messfehler, z.B. bei sich schnell ändernden Messgrößen, eine simultane bzw. quasisimultane Abtastung vorzusehen.

Bei weiteren beispielhaften Ausführungsformen können z.B. vier dedizierte Analog/Digital-Wandler, z.B. in dem Block e1, vorgesehen sein.

Bei weiteren beispielhaften Ausführungsformen beträgt eine Auflösung der Analog/Digital-Wandler z.B. 12 bit oder mehr, und eine Abtastrate beträgt z.B. 1 MHz (Megahertz) oder mehr.

Bei weiteren beispielhaften Ausführungsformen kann die Recheneinrichtung e1 einen Betrieb des Frequenz-Synthesizers e2 z.B. über eine serielle Schnittstelle steuern, z.B., um Anweisungen zum Einstellen einer gewünschten Frequenz für das bzw. die Signale AS, RS zu übertragen.

Bei weiteren beispielhaften Ausführungsformen ist der Frequenz-Synthesizer e2 dazu ausgebildet, eine Frequenz des von ihm erzeugten Signals AS, RS im Kilohertz-Bereich genau einzustellen, also z.B. auf weniger als 100 kHz genau, beispielsweise weniger als 10 kHz genau, und beispielsweise ein möglichst schnelles Einschwingen zu gewährleisten.

Bei weiteren beispielhaften Ausführungsformen ist der Frequenz-Synthesizer e2 dazu ausgebildet, eine direkte digitale Synthese (DDS) auszuführen, um das bzw. die Signale AS, RS zu erzeugen.

Bei weiteren beispielhaften Ausführungsformen wird das von dem Frequenz-Synthesizer e2 erzeugte Signal AS, RS und/oder das von dem Resonator SAW gesendete Signal AS' von dem 3-Tor-Schalter e3, der bei weiteren beispielhaften Ausführungsformen z.B. durch die Recheneinrichtung e1 gesteuert wird, entsprechend umgeleitet. Folglich ergeben sich bei weiteren beispielhaften Ausführungsformen z.B. drei "Schalterstellungen". In einer ersten Stellung des 3-Tor-Schalters e3 kann z.B. das Signal von dem Synthesizer e2 zu der Sechs-Tor-Schaltung bzw. der Verzögerungseinrichtung e4 weitergeleitet werden, was bei weiteren beispielhaften Ausführungsformen z.B. für eine Linearisierung nutzbar ist. Mit einer zweiten Schalterstellung erfolgt bei weiteren beispielhaften Ausführungsformen die Anregung des Resonators SAW, wobei das von dem Block e2 erzeugte Signal als Anregungssignal AS zu dem Resonator SAW gesendet wird. Bei weiteren beispielhaften Ausführungsformen kann kurz danach der 3-Tor-Schalter auf eine dritte Schalterstellung umstellen, um das Antwortsignal AS' zu der Verzögerungseinrichtung e4 weiterzuleiten. Bei weiteren beispielhaften Ausführungsformen kann dieses Umschalten z.B. auch zur zeitlichen Fensterung des der Sechs-Tor-Schaltung e5 zuführbaren Signals verwendet werden.

Bei weiteren beispielhaften Ausführungsformen können z.B. ein oder mehrere Verstärker, beispielsweise rauscharme Verstärker (low-noise amplifiers, LNAs) (nicht gezeigt), vorgesehen sein, z.B. in einem Empfangspfad, wodurch das Signal-Rausch-Verhältnis (signal-to-noise ratio, SNR) erhöht werden kann.

Bei weiteren beispielhaften Ausführungsformen ist die Koppeleinrichtung e3a beispielsweise als Hochfrequenzkoppler, z.B. für eine kontaktlose Messung von physikalischen Größen, z.B. bezüglich eines rotierenden Bauteils, z.B. einer Welle, ausgebildet. Bei weiteren beispielhaften Ausführungsformen ermöglicht die Koppeleinrichtung e3a eine kontaktlose Übertragung der Signale AS, AS', bei denen es sich bei weiteren beispielhaften Ausführungsformen z.B. um Hochfrequenzsignale im Bereich von z.B. 2 GHz handelt, zum Anregen und Messen z.B. auch bei vergleichsweise großen Drehzahlen.

Der Koppler e3a kann bei weiteren beispielhaften Ausführungsformen z.B. ein stationäres Bauteil und ein z.B. mit der Welle mitdrehendes Bauteil aufweisen, das bei weiteren beispielhaften Ausführungsformen z.B. drehfest mit der Welle verbunden ist.

Bei weiteren beispielhaften Ausführungsformen ist der Resonator SAW als SAW-Sensor, beispielsweise als resonanter SAW-Sensor, z.B. mit einer Resonanzfrequenz größer 2 GHz, beispielsweise zwischen 2 GHz und 3 GHz, z.B. gemäß einem ISM-Band , ausgebildet.

Bei weiteren beispielhaften Ausführungsformen kann sich z.B. eine durch ein Drehmoment verursachte Verformung der Welle nach der Anregung des Resonators AW mit dem Anregungssignal AS auf das Antwortsignal AS' auswirken, z.B. als Frequenzverschiebung der Resonanzfrequenz des Resonators SAW. Bei weiteren beispielhaften Ausführungsformen ist die Veränderung der Resonanzfrequenz des Resonators SAW z.B. von der Drehmomentänderung abhängig.

Weitere beispielhafte Ausführungsformen, Fig. 2, beziehen sich auf ein Verfahren zum Betreiben einer Vorrichtung 100 mit einer Sechs-Tor-Schaltung 110, einer Verzögerungseinrichtung 120, und einer Recheneinrichtung 130, aufweisend: Teilen 200, mittels der Verzögerungseinrichtung 120, eines Eingangssignals S0 in ein erstes Eingangssignal S0-1 und ein zweites Eingangssignal S0-2, Verzögern 202 des ersten Eingangssignals S0-1 um eine erste Verzögerungszeit TD-1, mittels der Verzögerungseinrichtung 120, wobei beispielsweise ein erstes verzögertes Eingangssignal S0-1' erhalten wird, Verzögern 204 (z.B. gleichzeitig zu dem Verzögern 202) des zweiten Eingangssignals S0-2 um eine zweite Verzögerungszeit TD-2, mittels der Verzögerungseinrichtung 120, wobei beispielsweise ein zweites verzögertes Eingangssignal S0-2' erhalten wird, wobei die zweite Verzögerungszeit TD-2 verschieden ist von der ersten Verzögerungszeit TD-1, Ausgeben 206 , mittels der Verzögerungseinrichtung 120, des ersten verzögerten Eingangssignals S0-1' an einen ersten Eingang E1 der Sechs-Tor-Schaltung 110, Ausgeben 207, mittels der Verzögerungseinrichtung 120, des zweiten verzögerten Eingangssignals S0-2' an einen zweiten Eingang E2 der Sechs-Tor-Schaltung 110, Ermitteln 208, mittels der Recheneinrichtung 130, einer eine Frequenz des Eingangssignals S0 charakterisierenden erste Größe G1 in Abhängigkeit wenigstens eines Ausgangssignals SA1, SA2, SA3, SA4, beispielsweise in Abhängigkeit aller vier Ausgangssignale SA1, SA2, SA3, SA4, der Sechs-Tor-Schaltung 110.

Bei weiteren beispielhaften Ausführungsformen ist vorgesehen, dass die Verzögerungseinrichtung 120 eine erste Oberflächenwellen-, OFW-, Verzögerungsleitung 121 (Fig. 3) und eine zweite Oberflächenwellen-, OFW-, Verzögerungsleitung 122 aufweist, wobei das Verfahren aufweist: Verzögern 202, mittels der ersten Oberflächenwellen-, OFW-, Verzögerungsleitung 121, des ersten Eingangssignals S0-1 um die erste Verzögerungszeit TD-1, Verzögern 204, mittels der zweiten Oberflächenwellen-, OFW-, Verzögerungsleitung 122, des zweiten Eingangssignals S0-2 um die zweite Verzögerungszeit TD-2.

Bei weiteren beispielhaften Ausführungsformen, Fig. 7, ist vorgesehen, dass das Verfahren wenigstens eines der folgenden Elemente aufweist: a) Anschalten e10 bzw. Initialisieren der Vorrichtung 100 bzw. eines die Vorrichtung aufweisenden Messsystems 1000, 1000', b) Ermitteln e11 einer Hauptresonanz eines bzw. des Resonators SAW, c) Ausführen e12 einer Leistungskalibrierung, d) Ausführen e13 einer Linearisierung, e) Ermitteln e14 der ersten Größe G1 bzw. der Frequenz des Eingangssignals S0, optional Anpassen einer Frequenz eines an den Resonator SAW gesendeten Anregungssignals AS, und, optional, Wiederholen von Block e13, vgl. den Pfeil e15.

Bei weiteren beispielhaften Ausführungsformen weist das Ermitteln e11 der Hauptresonanz auf: Anregen, z.B. zeitlich aufeinanderfolgendes Anregen, des Resonators SAW mit Anregungssignalen unterschiedlichen Frequenzen, Ermitteln einer Leistung eines jeweiligen Antwortsignals für die unterschiedlichen Frequenzen, Verwenden derjenigen Frequenz der unterschiedlichen Frequenzen als Haupt-Resonanzfrequenz, bei der die ermittelte Leistung maximal ist.

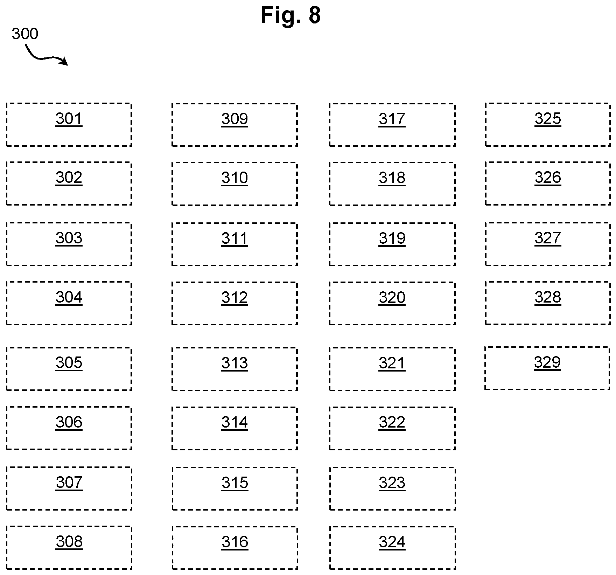

Weitere beispielhafte Ausführungsformen, Fig. 8, beziehen sich auf eine Verwendung 300 der Vorrichtung 100 gemäß den Ausführungsformen und/oder des Messsystems 1000, 1000' gemäß den Ausführungsformen und/oder des Verfahrens gemäß den Ausführungsformen für wenigstens eines der folgenden Elemente bzw. auf wenigstens einem der folgenden Gebiete: a) Ermitteln 301 einer eine Frequenz des Eingangssignals S0 charakterisierenden ersten Größe G1, b) Messung 302 von mechanischen Spannungen, beispielsweise charakterisierbar bzw. assoziierbar mit Biegung und/oder Stauchung und/oder Dehnung und/oder Torsion, c) Messung 303 eines Drehmoments, d) Messung 304 einer Kraft, e) Messung 305 einer Temperatur, f) Messung 306 eines Drucks, g) Messung 307 von Vibration bzw. Vibrationen, h) Messung 308 von Schock, i) Messung 309 von Resonanzen, j) Automotive 310, z.B. Getriebe, Zapfwellen, Achsen, Lenksäulen, tragende Karosseriekomponenten, k) E-Bikes 311 bzw. Pedelecs, l) Arbeitsmaschinen 312, beispielsweise mobile Arbeitsmaschinen, beispielsweise Getriebe, Zapfwellen, Achsen, Lenksäulen, tragenden Karosseriekomponenten, Dämpfer, Stoßdämpfer, m) elektrische Antriebe 313, n) Bauwerke 314 bzw. Gebäude, beispielsweise bezüglich Statik, Bauwerkskomponenten, Brückenüberwachung, Windlast, Erdbebenmonitoring, Erfassung beispielsweise geologischer Veränderungen, Schneelast, Belastung, Gebäudemonitoring, o) Energieerzeugung 315, beispielsweise Kraftwerksapplikationen, Windkraftanlagen, Rotorblattmonitoring, Pitchverstellung, Wasserkraft, p) Gewichtserfassung 316, beispielsweise Waagen, industrielles Wiegen, Überlastschutz, q) Temperaturmessung 317 und/oder - überwachung, beispielsweise, Öfen, Kochen, Fleischzubereitung und/oder -verarbeitung, r) Aufzüge 318, beispielsweise Lasten-/Personenaufzüge, s) industrielle Anwendungen 319 im Maschinenbau, beispielsweise Messtechnik für Prüf- und Teststände, t) Überwachung 320, beispielsweise Steuerung und/oder Regelung von Turbinen, Pumpen, Pressen, Stanzen, Umformen, u) Medizintechnik 321, beispielsweise Exoskellette, Protesen, OP-Tische, Betten, v) Luft- und Raumfahrt 322, beispielsweise Fahrwerksbelastung, Tragflächenmonitoring, Überwachung Steuerruder, w) Schifffahrt 323, beispielsweise Marineanwendungen, x) Bahnanwendungen 324, beispielsweise Gleisbau, Antriebstechnik, Zuglast, y) Umsetzung 325 einer funktionalen Sicherheit, z) Weiße Ware 326, Waschmaschine, Trommelüberwachung, Trockner, A) Fluidtechnik 327, Ventile, Klappen, Rohre, B) Qualitätssicherung 328, beispielsweise Prozessüberwachung.

**Patentansprüche**

1. Vorrichtung (100) mit einer Sechs-Tor-Schaltung (110), einer Verzögerungseinrichtung (120), und einer Recheneinrichtung (130), wobei die Verzögerungseinrichtung (120) dazu ausgebildet ist, ein Eingangssignal (S0) in ein erstes Eingangssignal (S0-1) und ein zweites Eingangssignal (S0-2) zu teilen (200), das erste Eingangssignal (S0-1) um eine erste Verzögerungszeit (TD-1) zu verzögern (202), wobei ein erstes verzögertes Eingangssignal (S0-1') erhalten wird, das zweite Eingangssignal (S0-2) um eine zweite Verzögerungszeit (TD-2) zu verzögern (204), wobei ein zweites verzögertes Eingangssignal (S0-2') erhalten wird, wobei die zweite Verzögerungszeit (TD-2) verschieden ist von der ersten Verzögerungszeit (TD-1), wobei die Verzögerungseinrichtung (120) dazu ausgebildet ist, das erste verzögerte Eingangssignal (S0-1') an einen ersten Eingang (E1) der Sechs-Tor-Schaltung (110) auszugeben (206), das zweite verzögerte Eingangssignal (S0-2') an einen zweiten Eingang (E2) der Sechs-Tor-Schaltung (110) auszugeben (207), wobei die Recheneinrichtung (130) dazu ausgebildet ist, eine eine Frequenz des Eingangssignals (S0) charakterisierende erste Größe (G1) in Abhängigkeit wenigstens eines Ausgangssignals (SA1, SA2, SA3, SA4) der Sechs-Tor-Schaltung (110) zu ermitteln (208), wobei die Verzögerungseinrichtung (120) eine erste Oberflächenwellen-, OFW-, Verzögerungsleitung (121) aufweist, die dazu ausgebildet ist, das erste Eingangssignal (S0-1) um die erste Verzögerungszeit (TD-1) zu verzögern (202), und wobei die Verzögerungseinrichtung (120) eine zweite Oberflächenwellen-, OFW-, Verzögerungsleitung (122) aufweist, die dazu ausgebildet ist, das zweite Eingangssignal (S0-2) um die zweite Verzögerungszeit (TD-2) zu verzögern (202), wobei die Verzögerungseinrichtung (120) eine Schaltungsträgerplatte (125) aufweist, und wobei die erste OFW-Verzögerungsleitung (121) und die zweite OFW-Verzögerungsleitung (122) auf der Schaltungsträgerplatte (125) angeordnet sind.

2. Vorrichtung (100) nach Anspruch 1, wobei die Verzögerungseinrichtung (120) eine erste Leiterstruktur (LS-1) aufweist, die dazu ausgebildet ist, das erste Eingangssignal (S0-1) um die erste Verzögerungszeit (TD-1) zu verzögern (202), und/oder wobei die Verzögerungseinrichtung (120) eine zweite Leiterstruktur (LS-2) aufweist, die dazu ausgebildet ist, das zweite Eingangssignal (S0-2) um die zweite Verzögerungszeit (TD-2) zu verzögern (202).

3. Vorrichtung (100) nach wenigstens einem der vorstehenden Ansprüche, wobei die Verzögerungseinrichtung (120) eine Leistungsteilereinrichtung (123) aufweist, die dazu ausgebildet ist, das Eingangssignal (S0) in das erste Eingangssignal (S0-1) und das zweite Eingangssignal (S0-2) zu teilen.

4. Vorrichtung (100) nach wenigstens einem der vorstehenden Ansprüche, wobei die erste OFW-Verzögerungsleitung (121) und/oder die zweite OFW-Verzögerungsleitung (122) jeweils als diskrete OFW-Verzögerungsleitung ausgebildet ist.

5. Vorrichtung (100) nach wenigstens einem der vorstehenden Ansprüche, wobei zusätzlich wenigstens eines der folgenden Elemente auf der Schaltungsträgerplatte (125) angeordnet ist: a) die Leistungsteilereinrichtung (123), b) die erste Leiterstruktur (LS-1), c) die zweite Leiterstruktur (LS-2).

6. Vorrichtung (100) nach wenigstens einem der vorstehenden Ansprüche, wobei ein Betrag einer Differenz zwischen der ersten Verzögerungszeit (TD-1) und der zweiten Verzögerungszeit (TD-2) zwischen etwa 1 Nanosekunde, ns, und etwa 1000 ns liegt.

7. Vorrichtung (100) nach wenigstens einem der vorstehenden Ansprüche, wobei die erste Verzögerungszeit (TD-1) und/oder die zweite Verzögerungszeit (TD-2) zwischen etwa 0,5 Mikrosekunden, $\mu$s, und etwa 10 $\mu$s liegt.

8. Messsystem (1000; 1000') aufweisend wenigstens eine Vorrichtung (100) nach wenigstens einem der vorstehenden Ansprüche und wenigstens eine Signalquelle, die dazu ausgebildet ist, das Eingangssignal (S0) bereitzustellen.

9. Messsystem (1000; 1000') nach Anspruch 8, wobei die wenigstens eine Signalquelle ein Resonator (SAW) ist.

10. Messsystem (1000; 1000') nach Anspruch 8 oder 9, wobei das Messsystem (1000; 1000') zur Messung wenigstens einer der folgenden Größen ausgebildet ist: a) mechanische Spannungen, b) Drehmoment, c) Kraft, d) Temperatur, e) Druck, f) Vibration, g) Schock, h) Resonanzen, i) Scherkräfte, j) Querkräfte, k) Elastizität, l) Verformung, m) Kontraktion.

11. Messsystem (1000; 1000') nach wenigstens einem der Ansprüche 8 bis 10, wobei das Messsystem (1000; 1000') wenigstens einen Signalgenerator (SG) aufweist, der dazu ausgebildet ist, ein Signal bereitzustellen.

12. Messsystem (1000; 1000') nach einem der Ansprüche 8 bis 11, wobei das Messsystem (1000; 1000') eine Koppeleinrichtung (e3a) aufweist, die dazu ausgebildet ist, ein bzw. das Anregungssignal (AS) an wenigstens einen Resonator (SAW) auszugeben und ein Ausgangssignal (AS') des wenigstens einen Resonators (SAW) zu empfangen und an wenigstens einen Eingang (E1, E2) der Sechs-Tor-Schaltung (110) und/oder an die Verzögerungseinrichtung (120; e4) auszugeben.

13. Verfahren zum Betreiben einer Vorrichtung (100) mit einer Sechs-Tor-Schaltung (110), einer Verzögerungseinrichtung (120), und einer Recheneinrichtung (130), aufweisend: Teilen (200), mittels der Verzögerungseinrichtung (120), eines Eingangssignals (S0) in ein erstes Eingangssignal (S0-1) und ein zweites Eingangssignal (S0-2), Verzögern (202) des ersten Eingangssignals (S0-1) um eine erste Verzögerungszeit (TD-1), mittels der Verzögerungseinrichtung (120), wobei ein erstes verzögertes Eingangssignal (S0-1') erhalten wird, Verzögern (204) des zweiten Eingangssignals (S0-2) um eine zweite Verzögerungszeit (TD-2), mittels der Verzögerungseinrichtung (120), wobei ein zweites verzögertes Eingangssignal (S0-2') erhalten wird, wobei die zweite Verzögerungszeit (TD-2) verschieden ist von der ersten Verzögerungszeit (TD-1), Ausgeben (206), mittels der Verzögerungseinrichtung (120), des ersten verzögerten Eingangssignals (S0-1') an einen ersten Eingang (E1) der Sechs-Tor-Schaltung (110), Ausgeben (207), mittels der Verzögerungseinrichtung (120), des zweiten verzögerten Eingangssignals (S0-2') an einen zweiten Eingang (E2) der Sechs-Tor-Schaltung (110), Ermitteln (208), mittels der Recheneinrichtung (130), einer eine Frequenz des Eingangssignals (S0) charakterisierenden erste Größe (G1) in Abhängigkeit wenigstens eines Ausgangssignals (SA1, SA2, SA3, SA4) der Sechs-Tor-Schaltung (110), wobei die Verzögerungseinrichtung (120) eine erste Oberflächenwellen, OFW-, Verzögerungsleitung (121) und eine zweite Oberflächenwellen, OFW-, Verzögerungsleitung (122) aufweist, wobei das Verzögern (202) des ersten Eingangssignals (S0-1) um die erste Verzögerungszeit (TD-1) mittels der ersten Oberflächenwellen, OFW-, Verzögerungsleitung (121) ausgeführt wird, wobei das Verzögern (204) des zweiten Eingangssignals (S0-2) um die zweite Verzögerungszeit (TD-2) mittels der zweiten Oberflächenwellen, OFW-, Verzögerungsleitung (122) ausgeführt wird, wobei die Verzögerungseinrichtung (120) eine Schaltungsträgerplatte (125) aufweist, und wobei die erste OFW-Verzögerungsleitung (121) und die zweite OFW-Verzögerungsleitung (122) auf der Schaltungsträgerplatte (125) angeordnet sind.

14. Verfahren nach Anspruch 13, weiter aufweisend wenigstens eines der folgenden Elemente: a) Anschalten (e10) bzw. Initialisieren der Vorrichtung (100) bzw. eines die Vorrichtung (100) aufweisenden Messsystems (1000; 1000'), b) Ermitteln (e11) einer Hauptresonanz eines Resonators (SAW), c) Ausführen (e12) einer Leistungskalibrierung, d) Ausführen (e13) einer Linearisierung, e) Ermitteln (e14) der ersten Größe (G1) bzw. der Frequenz des Eingangssignals (S0), optional Anpassen einer Frequenz eines an den Resonator (SAW) gesendeten Anregungssignals (AS).

15. Verwendung (300) der Vorrichtung (100) nach wenigstens einem der Ansprüche 1 bis 7 und/oder des Messsystems (1000; 1000') nach wenigstens einem der Ansprüche 8 bis 12 und/oder des Verfahrens nach wenigstens einem der Ansprüche 13 bis 14 für wenigstens eines der folgenden Elemente bzw. auf wenigstens einem der folgenden Gebiete: a) Ermitteln (301) einer eine Frequenz des Eingangssignals (S0) charakterisierenden ersten Größe (G1), b) Messung (302) von mechanischen Spannungen, c) Messung (303) eines Drehmoments, d) Messung (304) einer Kraft, e) Messung (305) einer Temperatur, f) Messung (306) eines Drucks, g) Messung (307) von Vibration bzw. Vibrationen, h) Messung (308) von Schock, i) Messung (309) von Resonanzen, j) Automotive (310), z.B. Getriebe, Zapfwellen, Achsen, Lenksäulen, tragende Karosseriekomponenten, k) E-Bikes (311) bzw. Pedelecs, l) Arbeitsmaschinen (312), m) elektrische Antriebe (313), n) Bauwerke (314) bzw. Gebäude, o) Energieerzeugung (315), p) Gewichtserfassung (316), q) Temperaturmessung (317) und/oder -überwachung, , r) Aufzüge (318), s) industrielle Anwendungen (319) im Maschinenbau, t) Überwachung (320), u) Medizintechnik (321), , v) Luft- und Raumfahrt (322), w) Schifffahrt (323), x) Bahnanwendungen (324), y) Umsetzung (325) einer funktionalen Sicherheit, z) Weiße Ware (326), A) Fluidtechnik (327), Ventile, Klappen, Rohre, B) Qualitätssicherung (328), C) Ermittlung (329) und/oder Auswertung von chemischen Zusammensetzungen von Fluiden.

**Claims**

1. Apparatus (100) comprising a six-port circuit (110), a delay device (120), and a computing device (130), wherein the delay device (120) is designed to divide (200) an input signal (S0) into a first input signal (S0-1) and a second input signal (S0-2), to delay (202) the first input signal (S0-1) by a first delay time (TD-1), a first delayed input signal (S0-1') thereby being obtained, and to delay (204) the second input signal (S0-2) by a second delay time (TD-2), a second delayed input signal (S0-2') thereby being obtained, wherein the second delay time (TD-2) is different from the first delay time (TD-1), wherein the delay device (120) is designed to output (206) the first delayed input signal (S0-1') to a first input (E1) of the six-port circuit (110), and to output (207) the second delayed input signal (S0-2') to a second input (E2) of the six-port circuit (110), wherein the computing device (130) is designed to ascertain (208), on the basis of at least one output signal (SA1, SA2, SA3, SA4) of the six-port circuit (110), a first variable (G1) characterizing a frequency of the input signal (S0),
wherein the delay device (120) has a first surface wave, SW, delay line (121) designed to delay (202) the first input signal (S0-1) by the first delay time (TD-1), and wherein the delay device (120) has a second surface wave, SW, delay line (122) designed to delay (202) the second input signal (S0-2) by the second delay time (TD-2), wherein the delay device (120) has a circuit carrier plate (125), and wherein the first SW delay line (121) and the second SW delay line (122) are arranged on the circuit carrier plate (125).

2. Apparatus (100) according to claim 1, wherein the delay device (120) has a first conductor structure (LS-1) designed to delay (202) the first input signal (S0-1) by the first delay time (TD-1), and/or wherein the delay device (120) has a second conductor structure (LS-2) designed to delay (202) the second input signal (S0-2) by the second delay time (TD-2).

3. Apparatus (100) according to at least one of the preceding claims, wherein the delay device (120) has a power divider device (123) designed to divide the input signal (S0) into the first input signal (S0-1) and the second input signal (S0-2).

4. Apparatus (100) according to at least one of the preceding claims, wherein the first SW delay line (121) and/or the second SW delay line (122) is designed as a discrete SW delay line in each case.

5. Apparatus (100) according to at least one of the preceding claims, wherein at least one of the following elements is additionally arranged on the circuit carrier plate (125): a) the power divider device (123), b) the first conductor structure (LS-1), and c) the second conductor structure (LS-2).

6. Apparatus (100) according to at least one of the preceding claims, wherein a value of a difference between the first delay time (TD-1) and the second delay time (TD-2) is between about 1 nanosecond, ns, and about 1000 ns.

7. Apparatus (100) according to at least one of the preceding claims, wherein the first delay time (TD-1) and/or the second delay time (TD-2) is between about 0.5 microseconds, $\mu$s, and about 10 $\mu$s.

8. Measuring system (1000; 1000') having at least one apparatus (100) according to at least one of the preceding claims and at least one signal source designed to provide the input signal (S0).

9. Measuring system (1000; 1000') according to claim 8, wherein the at least one signal source is a resonator (SAW) .

10. Measuring system (1000; 1000') according to claim 8 or 9, wherein the measuring system (1000; 1000') is designed to measure at least one of the following variables: a) mechanical stresses, b) torque, c) force, d) temperature, e) pressure, f) vibration, g) shock, h) resonances, i) shear forces, j) transverse forces, k) elasticity, l) deformation, and m) contraction.

11. Measuring system (1000; 1000') according to at least one of claims 8 to 10, wherein the measuring system (1000; 1000') has at least one signal generator (SG) designed to provide a signal.

12. Measuring system (1000; 1000') according to any of claims 8 to 11, wherein the measuring system (1000; 1000') has a coupling device (e3a) designed to output a or the excitation signal (AS) to at least one resonator (SAW), and to receive an output signal (AS') from the at least one resonator (SAW) and to output said signal to at least one input (E1, E2) of the six-port circuit (110) and/or to the delay device (120; e4).

13. Method for operating an apparatus (100) comprising a six-port circuit (110), a delay device (120), and a computing device (130), having the steps of: dividing (200), by means of the delay device (120), an input signal (S0) into a first input signal (S0-1) and a second input signal (S0-2), delaying (202) the first input signal (S0-1) by a first delay time (TD-1) by means of the delay device (120), a first delayed input signal (S0-1') thereby being obtained, delaying (204) the second input signal (S0-2) by a second delay time (TD-2) by means of the delay device (120), a second delayed input signal (S0-2') thereby being obtained, wherein the second delay time (TD-2) is different from the first delay time (TD-1), outputting (206), by means of the delay device (120), the first delayed input signal (S0-1') to a first input (E1) of the six-port circuit (110), outputting (207), by means of the delay device (120), the second delayed input signal (S0-2') to a second input (E2) of the six-port circuit (110), ascertaining (208), by means of the computing device (130) and on the basis of at least one output signal (SA1, SA2, SA3, SA4) of the six-port circuit (110), a first variable (G1) characterizing a frequency of the input signal (S0), wherein the delay device (120) has a first surface wave, SW, delay line (121) and a second surface wave, SW, delay line (122), wherein the step of delaying (202) the first input signal (S0-1) by the first delay time (TD-1) is carried out by means of the first surface wave, SW, delay line (121), wherein the step of delaying (204) the second input signal (S0-2) by the second delay time (TD-2) is carried out by means of the second surface wave, SW, delay line (122), wherein the delay device (120) has a circuit carrier plate (125), and wherein the first SW delay line (121) and the second SW delay line (122) are arranged on the circuit carrier plate (125).

14. Method according to claim 13, further having at least one of the following elements: a) switching on (e10) or initializing the apparatus (100) or a measuring system (1000; 1000') having the apparatus (100), b) ascertaining (e11) a main resonance of a resonator (SAW), c) carrying out (e12) a power calibration, d) carrying out (e13) a linearization process, and e) ascertaining (e14) the first variable (G1) or the frequency of the input signal (S0), optionally adjusting a frequency of an excitation signal (AS) sent to the resonator (SAW).

15. Use (300) of the apparatus (100) according to at least one of claims 1 to 7 and/or of the measuring system (1000; 1000') according to at least one of claims 8 to 12 and/or of the method according to at least one of claims 13 and 14 for at least one of the following elements or in at least one of the following areas: a) ascertaining (301) a first variable (G1) characterizing a frequency of the input signal (S0), b) measuring (302) mechanical stresses, c) measuring (303) a torque, d) measuring (304) a force, e) measuring (305) a temperature, f) measuring (306) a pressure, g) measuring (307) vibration or vibrations, h) measuring (308) shock, i) measuring (309) resonances, j) automotive (310), e.g. transmissions, power take-off shafts, axles, steering columns and load-bearing body components, k) e-bikes (311) or pedelecs, l) work machines (312), m) electric drives (313), n) structures (314) or buildings, o) energy generation (315), p) weight detection (316), q) temperature measurement (317) and/or monitoring, r) elevators (318), s) industrial applications (319) in mechanical engineering, t) monitoring (320), u) medical technology (321), v) aerospace (322), w) shipping (323), x) railway applications (324), y) implementation (325) of functional safety, z) white goods (326), A) fluid technology (327), valves, flaps and pipes, B) quality assurance (328), and C) ascertaining (329) and/or evaluation of chemical compositions of fluids.

**Revendications**

1. Dispositif (100) comprenant un circuit à six ports (110), un dispositif de retard (120) et un dispositif de calcul (130), dans lequel ledit dispositif de retard (120) est conçu pour diviser (200) un signal d'entrée (S0) en un premier signal d'entrée (S0-1) et un deuxième signal d'entrée (S0-2), pour retarder (202) le premier signal d'entrée (S0-1) d'une première durée de retard (TD-1), obtenant ainsi un premier signal d'entrée retardé (S0-1'), pour retarder (204) le deuxième signal d'entrée (S0-2) d'une deuxième durée de retard (TD-2), obtenant ainsi un deuxième signal d'entrée retardé (S0-2'), dans lequel la deuxième durée de retard (TD-2) est différente de la première durée de retard (TD-1), dans lequel le dispositif de retard (120) est conçu pour fournir (206) le premier signal d'entrée retardé (S0-1') à une première entrée (E1) du circuit à six ports (110), pour fournir (207) le deuxième signal d'entrée retardé (S0-2') à une deuxième entrée (E2) du circuit à six ports (110), dans lequel le dispositif de calcul (130) est conçu pour déterminer (208) une première grandeur (G1) caractérisant une fréquence du signal d'entrée (S0), en fonction d'au moins un signal de sortie (SA1, SA2, SA3, SA4) du circuit à six ports (110),

dans lequel le dispositif de retard (120) comprend une première ligne à retard à onde de surface, OFW, (121) qui est conçue pour retarder (202) le premier signal d'entrée (S0-1) de la première durée de retard (TD-1), et dans lequel le dispositif de retard (120) comprend une deuxième ligne à retard à onde de surface, OFW, (122) qui est conçue pour retarder (202) le deuxième signal d'entrée (S0-2) de la deuxième durée de retard (TD-2), dans lequel le dispositif de retard (120) comprend une plaque porteuse de circuit (125), et dans lequel la première ligne à retard OFW (121) et la deuxième ligne à retard OFW (122) sont disposées sur la plaque porteuse de circuit (125).

2. Dispositif (100) selon la revendication 1, dans lequel le dispositif de retard (120) comprend une première structure conductrice (LS-1) qui est conçue pour retarder (202) le premier signal d'entrée (S0-1) de la première durée de retard (TD-1), et/ou dans lequel le dispositif de retard (120) comprend une deuxième structure conductrice (LS-2) qui est conçu pour retarder (202) le deuxième signal d'entrée (S0-2) de la deuxième durée de retard (TD-2).

3. Dispositif (100) selon au moins l'une quelconque des revendications précédentes, dans lequel le dispositif de retard (120) comprend un dispositif diviseur de puissance (123) qui est conçu pour diviser le signal d'entrée (S0) en le premier signal d'entrée (S0-1) et le deuxième signal d'entrée (S0-2).

4. Dispositif (100) selon au moins l'une quelconque des revendications précédentes, dans lequel la première ligne à retard OFW (121) et/ou la deuxième ligne à retard OFW (122) sont chacune conçues en tant que ligne à retard OFW discrète.

**5.** Dispositif (100) selon au moins l'une quelconque des revendications précédentes, dans lequel au moins un des éléments suivants est en outre disposé sur la plaque porteuse de circuit (125): a) le dispositif diviseur de puissance (123), b) la première structure conductrice (LS-1), c) la deuxième structure conductrice (LS-2).

**6.** Dispositif (100) selon au moins l'une quelconque des revendications précédentes, dans lequel une valeur d'une différence entre la première durée de retard (TD-1) et la deuxième durée de retard (TD-2) est comprise entre environ 1 nanoseconde, ns, et environ 1000 ns.

**7.** Dispositif (100) selon au moins l'une quelconque des revendications précédentes, dans lequel la première durée de retard (TD-1) et/ou la deuxième durée de retard (TD-2) est comprise entre environ 0,5 microseconde, $\mu$s, et environ 10 $\mu$s.

**8.** Système de mesure (1000 ; 1000') comprenant au moins un dispositif (100) selon au moins l'une quelconque des revendications précédentes et au moins une source de signal qui est conçue pour fournir le signal d'entrée (S0).

**9.** Système de mesure (1000; 1000') selon la revendication 8, dans lequel ladite au moins une source de signal est un résonateur (SAW).

**10.** Système de mesure (1000; 1000') selon la revendication 8 ou 9, dans lequel le système de mesure (1000; 1000') est conçu pour mesurer au moins l'une des grandeurs suivantes: a) contraintes mécaniques, b) couple, c) force, d) température, e) pression, f) vibration, g) choc, h) résonances, i) forces de cisaillement, j) forces transversales, k) élasticité, l) déformation, m) contraction.

**11.** Système de mesure (1000; 1000') selon au moins l'une quelconque des revendications 8 à 10, dans lequel le système de mesure (1000; 1000') comprend au moins un générateur de signal (SG) qui est conçu pour fournir un signal.

**12.** Système de mesure (1000; 1000') selon l'une quelconque des revendications 8 à 11, dans lequel le système de mesure (1000; 1000') comprend un dispositif de couplage (e3a) qui est conçu pour fournir un ou bien le signal d'excitation (AS) à au moins un résonateur (SAW) et pour recevoir un signal de sortie (AS') dudit au moins un résonateur (SAW) et pour fournir celui-ci à au moins une entrée (E1, E2) du circuit à six ports (110) et/ou au dispositif de retard (120; e4).

**13.** Procédé destiné à faire fonctionner un dispositif (100) comprenant un circuit à six ports (110), un dispositif de retard (120) et un dispositif de calcul (130), comprenant: diviser (200) un signal d'entrée (S0) en un premier signal d'entrée (S0-1) et un deuxième signal d'entrée (S0-2) au moyen du dispositif de retard (120); retarder (202) le premier signal d'entrée (S0-1) d'une première durée de retard (TD-1) au moyen du dispositif de retard (120), obtenant ainsi un premier signal d'entrée retardé (S0-1'); retarder (204) le deuxième signal d'entrée (S0-2) d'une deuxième durée de retard (TD-2) au moyen du dispositif de retard (120), obtenant ainsi un deuxième signal d'entrée retardé (S0-2'), la deuxième durée de retard (TD-2) étant différente de la première durée de retard (TD-1), fournir (206), au moyen du dispositif de retard (120), le premier signal d'entrée retardé (S0-1') à une première entrée (E1) du circuit à six ports (110), fournir (207), au moyen du dispositif de retard (120), le deuxième signal d'entrée retardé (S0-2') à une deuxième entrée (E2) du même circuit à six ports (110), déterminer (208), au moyen du dispositif de calcul (130), une première grandeur (G1) caractérisant une fréquence du signal d'entrée (S0), en fonction d'au moins un signal de sortie (SA1, SA2, SA3, SA4) du circuit à six ports (110), dans lequel le dispositif de retard (120) comprend une première ligne à retard à onde de surface, OFW, (121) et une deuxième ligne à retard à onde de surface, OFW, (122), dans lequel le retard (202) du premier signal d'entrée (S0-1) de la première durée de retard. (TD-1) est réalisé au moyen de la première ligne à retard à ondes de surface, OFW, (121), dans lequel le retard (204) du deuxième signal d'entrée (S0-2) de la deuxième durée de retard (TD-2) est réalisé au moyen de la deuxième ligne à retard à ondes de surface, OFW, (122), dans lequel le dispositif de retard (120) comprend une plaque porteuse de circuit (125), et dans lequel la première ligne à retard OFW (121) et la deuxième ligne à retard OFW (122) sont disposées sur la plaque porteuse de circuit (125).

**14.** Procédé selon la revendication 13, comprenant en outre au moins un des éléments suivants: a) mettre en marche (e10) ou bien initialiser le dispositif (100) ou bien un système de mesure (1000; 1000') comprenant le dispositif (100); b) déterminer (e11) une résonance principale d'un résonateur (SAW); c) réaliser (e12) un étalonnage de puissance; d) réaliser (e13) une linéarisation; e) déterminer (e14) la première grandeur (G1) ou bien la fréquence du signal d'entrée (S0), en option adapter une fréquence d'un signal d'excitation (AS) envoyé au résonateur (SAW).

**15.** Utilisation (300) du dispositif (100) selon au moins l'une quelconque des revendications 1 à 7 et/ou du système de mesure (1000; 1000') selon au moins l'une quelconque des revendications 8 à 12 et/ou du procédé selon au moins l'une quelconque des revendications 13 à 14 pour au moins un des éléments suivants ou bien dans au moins un des domaines suivants: a) détermination (301) d'une première grandeur (G1) caractérisant une fréquence du signal d'entrée (S0), b) mesure (302) de contraintes mécaniques, c) mesure (303) d'un couple, d) mesure (304) d'une force, e) mesure (305) d'une température, f) mesure (306) d'une pression, g) mesure (307) de vibration ou bien vibrations, h) mesure (308) de choc, i) mesure (309) de résonances, j) automobile (310), par exemple. transmissions, prises de force, essieux, colonnes de direction, composants porteurs de la carrosserie, k) vélos électriques (311) ou bien vélos à assistance électrique, l) machines de travail (312), m) entraînements électriques (313), n) édifices (314) ou bien bâtiments, o) production d'énergie (315), p) mesure du poids (316), q) mesure (317) et/ou surveillance de la température, r) ascenseurs (318), s) applications industrielles (319) en génie mécanique, t) surveillance (320), u) technologie médicale (321), v) aérospatiale (322), w) transport maritime (323), x) applications ferroviaires (324), y) mise en œuvre (325) d'une sécurité fonctionnelle, z) gros électroménager (326), A) technologie des fluides (327), vannes, clapets, tuyaux, B) assurance qualité (328), C) détermination (329) et/ou évaluation de compositions chimiques de fluides.

# Fig. 1

# Fig. 2

## Fig. 3A

120

123

S0 → [ ] → S0-1 → [ 121 ] → S0-1'

S0-2 → [ 122 ] → S0-2'

## Fig. 3B

120'

123

LS-1

S0 → [ ] → S0-1 → ∿ → S0-1'

LS-2

S0-2 → ∿ → S0-2'

## Fig. 4

125

S0 → [ 123 ] → [ 121 ] → S0-1'

[ 122 ] → S0-2'

## Fig. 5

1000

100

120

110

130

[ SAW ] → S0 → [ 121 ] → S0-1' → [ E1 ]

[ 122 ] → S0-2' → [ E2 ]

AS ↗  ↖ RS

[ SG ]

[ A1 ] → SA1

[ A2 ] → SA2 → [ ] → G1

[ A3 ] → SA3

[ A4 ] → SA4

## Fig. 6

## Fig. 7

# Fig. 8

300

| | | | |
|---|---|---|---|
| 301 | 309 | 317 | 325 |
| 302 | 310 | 318 | 326 |
| 303 | 311 | 319 | 327 |
| 304 | 312 | 320 | 328 |
| 305 | 313 | 321 | 329 |
| 306 | 314 | 322 | |
| 307 | 315 | 323 | |
| 308 | 316 | 324 | |

**IN DER BESCHREIBUNG AUFGEFÜHRTE DOKUMENTE**

**In der Beschreibung aufgeführte Patentdokumente**

• DE 102013209364 A1

**In der Beschreibung aufgeführte Nicht-Patentliteratur**

• **SCHEINER BENEDICT et al.** Frequency Response Characterization of Surface Acoustic Wave Resonators Using a Six-Port Frequency Measurement System. *KLEINHEUBACH CONFERENCE, URSI LANDESAUSSCHUSS IN DER BUNDESREPUBLIK DEUTSCHLAND E.V*, 23 September 2019, 1-4